Europäisches Patentamt

European Patent Office

Office européen des brevets

(11) Numéro de publication : **0 432 035 A1**

# DEMANDE DE BREVET EUROPEEN

(21) Numéro de dépôt : **90403445.1**

(22) Date de dépôt : **04.12.90**

(51) Int. Cl.⁵ : **H01S 3/19, G02F 1/015, H01L 31/0352**

(30) Priorité : 05.12.89 FR 8916035

(43) Date de publication de la demande :
**12.06.91 Bulletin 91/24**

(84) Etats contractants désignés :
**DE GB**

(71) Demandeur : **THOMSON-CSF**
**51, Esplanade du Général de Gaulle**
**F-92800 Puteaux (FR)**

(72) Inventeur : **Weisbuch, Claude**
**THOMSON-CSF, SCPI, Cédex 67**
**F-92045 Paris la Défense (FR)**
Inventeur : **Bois, Philippe**
**THOMSON-CSF, SCPI, Cédex 67**
**F-92045 Paris la Défense (FR)**
Inventeur : **Vinter, Borge**
**THOMSON-CSF, SCPI, Cédex 67**
**F-92045 Paris la Défense (FR)**

(74) Mandataire : **Guérin, Michel et al**
**THOMSON-CSF SCPI**
**F-92045 PARIS LA DEFENSE CEDEX 67 (FR)**

(54) **Dispositif optique à puits quantiques et procédé de réalisation.**

(57)    Dispositif optique à puits quantiques comportant une couche (1) d'un matériau semiconducteur à grande largeur de bande interdite et, situé dans cette couche, au moins un puits quantique tel que fil quantique ou boîte quantique comportant un matériau (2) de largeur de bande interdite plus faible que celle de la couche (1).

Ce puits quantique possède deux niveaux électroniques permis (E1, E2). Des moyens permettent un peuplement en électrons du premier niveau électronique permis.

FIG.4a

# DISPOSITIF OPTIQUE A PUITS QUANTIQUES ET PROCEDE DE REALISATION

L'invention concerne un dispositif optique à puits quantique et plus particulièrement un dispositif à boîtes quantiques ou fils quantiques applicable dans les techniques optiques et optoélectroniques et des procédés de réalisation de ce dispositif.

Les dispositifs optiques et optoélectroniques dans le domaine des ondes électromagnétique de grandes longueurs d'onde, en particulier (>2 µm) n'ont jusqu'ici vu que peu de réalisations dans les semiconducteurs car il existe peu de niveaux d'énergie qui ne soient fortement couplés aux excitations du réseau. La seule exception est fournie par les semiconducteurs à petite bande interdite.

Nous proposons ici une nouvelle famille de dispositifs optiques et optoélectroniques dans lesquels des niveaux d'énergie sont déterminés à volonté par les dimensions de boîtes et de fils quantiques constituées de matériaux semiconducteurs insérés dans des matrices d'autres semiconducteurs.

La quantification des niveaux d'énergie d'électrons et de trous dans des films semi-conducteurs ultraminces (de l'ordre de, ou inférieures à 20 nm) est maintenant bien établie (voir l'article de C. Weisbuch : Fundamental Properties of III-V Semiconductor Two-Dimensional Quantized Structures : The Basis for Optical and Electronic Device Applications, Semiconductors and Semimetals, vol. 24, R. Dingle ed., Academic, New York 1987). Celle-ci est montrée sur la figure 1a, où l'on a représenté une couche de semiconducteur SC2 ultrafine placée entre deux semiconducteurs SC1 ET SC3. La structure des niveaux d'énergie pour des semiconducteurs bien choisis est montrée en 1b, ainsi que les niveaux quantifiés d'énergie pour les électrons ($E_1$, $E_2$) et les trous ($E'_1$, $E'_2$) dans la couche SC2

Dans l'approximation du puits de potentiel infiniment profond les niveaux d'énergie quantifiés successifs sont situés à une énergie, dite de confinement, située au-dessus du bas de bande et donnée par la formule :

$$E_n = n^2 \pi^2 \hbar^2 / 2m^* L^2$$

où

- n est : l'ordre de niveau ;
- $\hbar$ : la constante de Planck ;
- $m^*$ : la masse effective de la particule considérée (électron ou trou) ;
- L : l'épaisseur du film SC2.

On voit que l'on peut à volonté contrôler la différence entre les niveaux d'énergie par l'épaisseur du film. Cette possibilité est utilisée dans des détecteurs où la gamme de sensibilité en longueur d'onde est ajustée à la transition $E_1$ - $E_2$ par l'épaisseur du film.

Si l'épaisseur du film est suffisamment faible, il n'y a qu'un niveau d'énergie compris dans le puits, le niveau $E_2$ étant situé au-delà de $\Delta E_c$ dans le continuum des états des matériaux SC1 et SC3.

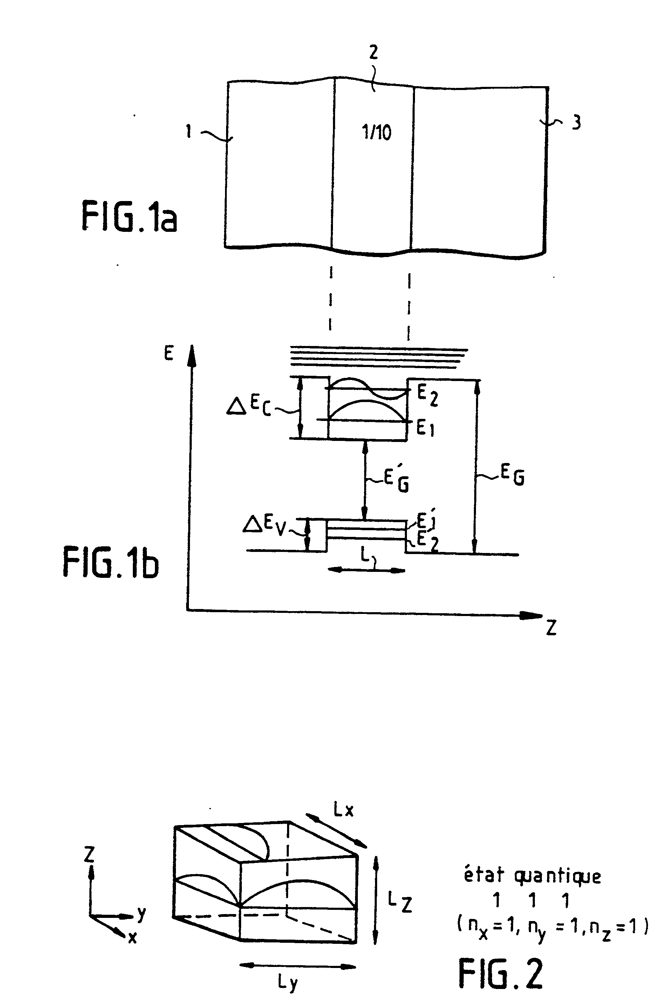

L'extension du concept de quantification des niveaux d'énergie dans les trois dimensions est immédiate : il suffit de considérer une boîte de semiconducteur insérée dans un autre semiconducteur : la fonction d'onde des électrons et des trous sera quantifiée dans la boîte si comme cela a été expliqué en relation avec la figure 1b, les niveaux d'énergie des électrons et des trous sont inférieurs dans le matériau constituant le cube par rapport au matériau alentour (voir figure 2).

La situation unique de ce système est que les niveaux d'énergie successifs, sont donnés dans l'approximation du puits infini, par la formule :

$$E_{nx,ny,nz} = \pi^2 \hbar^2 / 2m^* (nx^2/Lx^2 + ny^2/Ly^2 + nz^2/Lz^2)$$

où : (entiers positifs)
- nx, ny, nz sont les ordres de niveaux selon les trois directions x, y, z,
- Lx, Ly, Lz les épaisseurs de la boîte selon les trois directions x, y z.

Ces niveaux d'énergie $E_{nz, ny, nz}$ peuvent être séparés d'une énergie soit incommensurable avec tout phonon du cristal, soit supérieure à tous les phonons du cristal. Dans ce cas, il ne peut y avoir de relaxation d'énergie à travers les transitions à l'aide d'un seul phonon du cristal et le temps de vie des états excités devient extrêmement long, de l'ordre du temps de vie radiatif. Cette situation est différente de celles des films quantiques où l'énergie cinétique des électrons le long du film leur donne des niveaux d'énergie continus du type :

$$E_{nzk} = nz^2 \pi^2 \hbar^2 / 2 m^* Lz^2 + \hbar^2 k^2/2m^*$$

où k est le vecteur d'onde des électrons décrivant leur mouvement libre le long du plan.

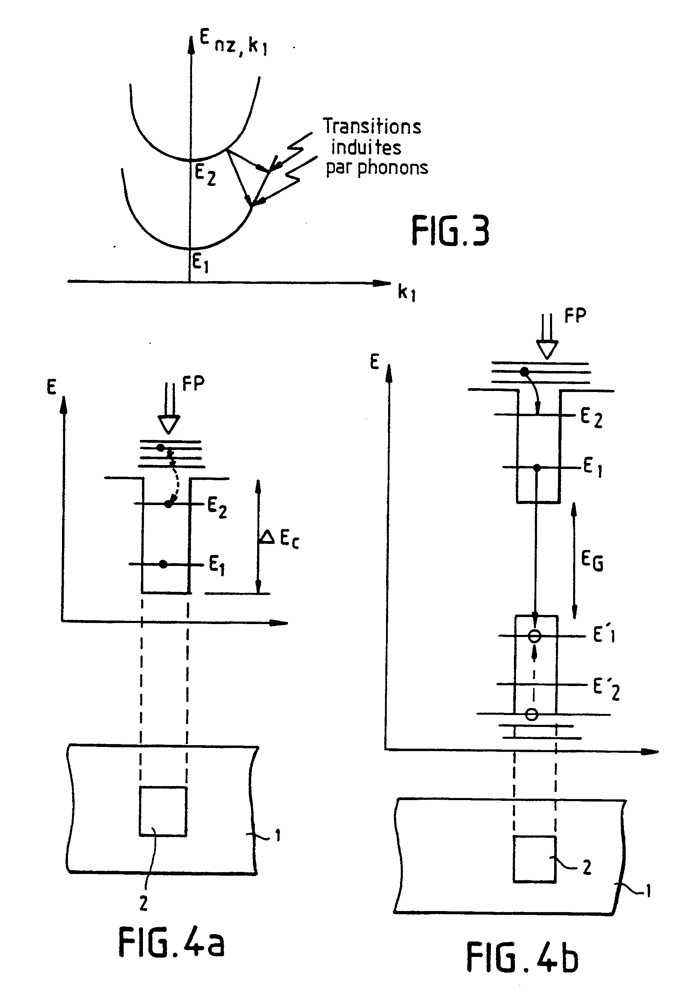

Du fait de ces niveaux d'énergie continus, il y a toujours des niveaux d'énergie possibles entre lesquels les phonons du réseau peuvent induire des transitions comme cela est représenté en figure 3.

L'invention tire profit de cette situation pour permettre la réalisation de dispositifs optiques comportant des puits quantiques aux dimensions limitées.

L'invention concerne donc un dispositif optique à puits quantique caractérisé en ce qu'il comporte :
- une couche d'un matériau semiconducteur transparent à des ondes lumineuses possédant une valeur d'énergie potentielle déterminée correspondant au bas de la bande de conduction pour les électrons ;
- au moins un puits quantique limité dans deux dimensions (fil quantique) ou dans trois dimensions (boîte quantique ou point quantique), le matériau constituant ce puits quantique de valeur d'énergie potentielle du bas de la bande de conduction est inférieure à celle de la couche de matériau semiconducteur transparent et possédant au moins un premier niveau électronique (niveau fondamental) et un deuxième niveau électronique permis (niveau excité) dont les énergies correspondantes sont comprises entre les valeurs d'énergie potentielle des bas de bandes de conduction précédentes ;
- des moyens de peuplement en électrons du premier niveau électronique permis.

Selon l'invention on prévoit une pluralité de puits à dimensions limitées (boîtes quantiques et lignes quantiques).

L'invention peut être appliquée à la réalisation d'un laser. On a donc un dispositif optique à puits quantique caractérisé en ce que :
- la couche étant orientée avec ses faces principales parallèles à un plan xy d'un trièdre xyz, les puits quantiques sont orientés selon la direction x ;
- des faces de la couche perpendiculaires à la direction x sont clivées ou traitées optiquement pour constituer une cavité optique ;
- une source auxiliaire fournit une onde de pompe sensiblement perpendiculaire aux faces principales.

On a également un dispositif optique caractérisé en ce que la couche du matériau semiconducteur transparent comporte deux faces principales parallèles à un plan yx d'un trièdre xyz et équipées chacune d'une électrode d'un même type de conductivité, un générateur de tension étant connecté à ces électrodes pour appliquer une différence de potentiel aux deux faces de la structure ; des faces de la couche perpendiculaire à la direction x sont clivées ou traitées pour constituer une cavité optique.

L'invention concerne également un détecteur tel qu'un dispositif optique caractérisé en ce qu'il comporte des électrodes d'un même type de conductivité sur les deux côtés de la couche de matériau semiconducteur transparent et un détecteur de différence de potentiel connecté à ces électrodes.

L'invention concerne également un modulateur de lumière tel qu'un dispositif optique caractérisé en ce qu'il comporte une électrode de chaque côté de la couche de matériau semiconducteur transparent et une source de tension appliquant une différence de potentiel aux électrodes, un faisceau lumineux étant transmis dans la couche pour être modulé par le dispositif.

Enfin l'invention concerne un procédé de réalisation d'un dispositif optique caractérisé en ce qu'il comporte :
- une première étape de réalisation sur un substrat de couches alternées de deux matériaux possédant des largeurs de bandes interdites différentes ;
- une deuxième étape de gravure dans ces couches d'éléments individuels ;

Les différents objets et caractéristiques de l'invention apparaîtront plus clairement dans la description qui va suivre faite à titre d'exemple et des figures annexées qui représentent :
- les figures 1 à 3, des diagrammes explicatifs du fonctionnement d'une boîte quantique ;
- les figures 4a et 4b, des diagrammes de fonctionnement de boîtes quantiques pour pompage optique selon l'invention ;
- la figure 5, un exemple de réalisation d'un laser à fils quantiques pompé optiquement ;
- la figure 6, un exemple de réalisation d'un laser à boîtes quantiques pompé optiquement ;
- la figure 9, un diagramme d'énergie du laser des figures 7 et 8 ;

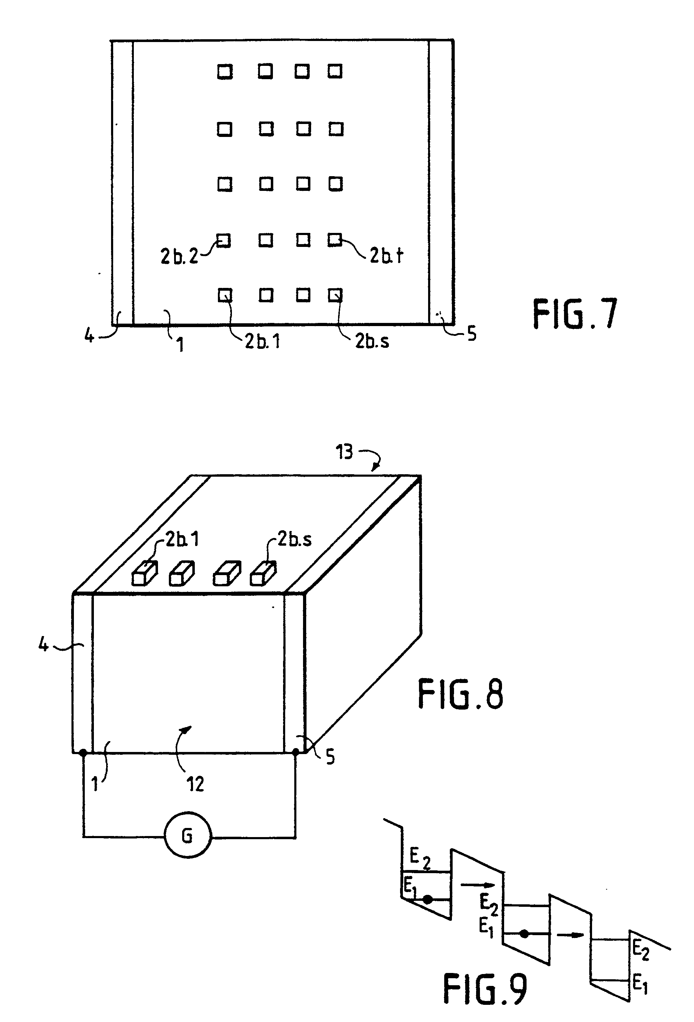

- les figures 7 et 8, un exemple de réalisation d'un laser excité électriquement ;

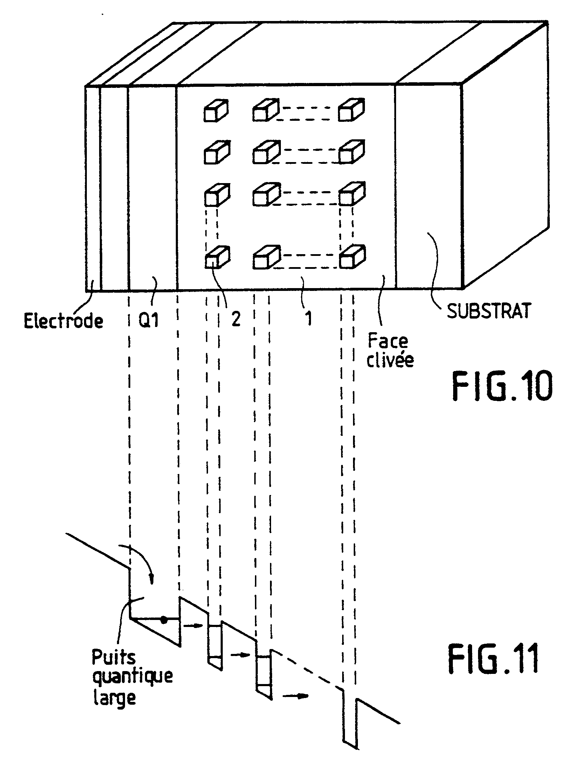

- la figure 10, une variante de réalisation du laser des figures 7 et 8 ;
- la figure 11, un diagramme d'énergie du laser de la figure 10 ;

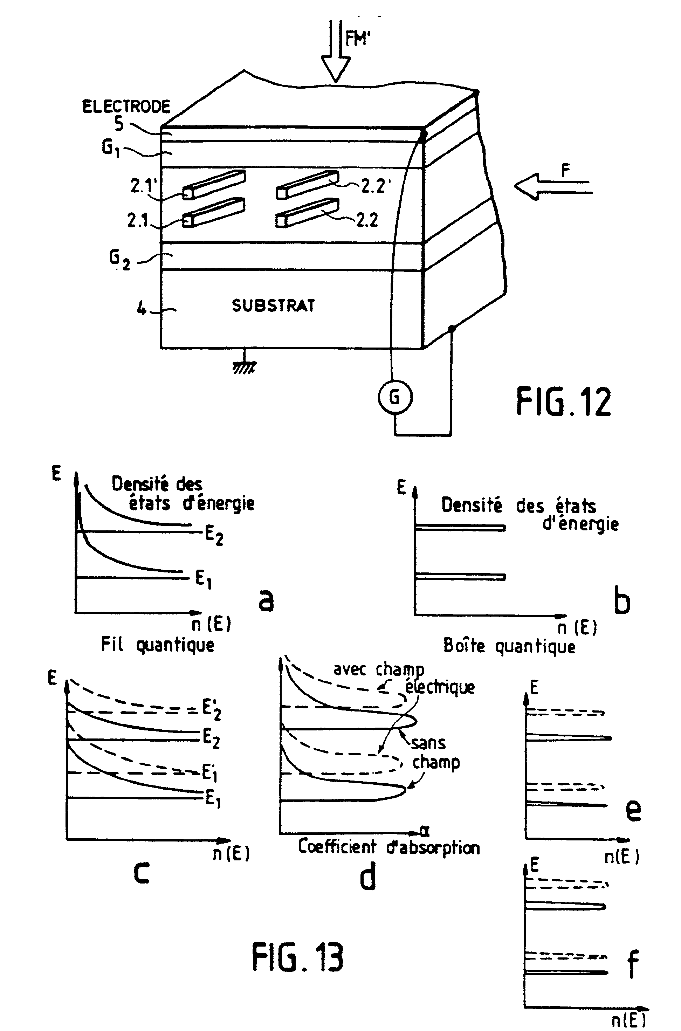

- les figures 12, un exemple de réalisation d'un modulateur à fils quantiques ;
- les figures 13a et 13b, des densités d'états dans des fils et des boîtes quantiques ;
- les figures 13c à 13f des courbes traduisant l'effet d'un champ électrique sur l'indice et le coefficient d'absorption dans des fils et des puits quantiques ;

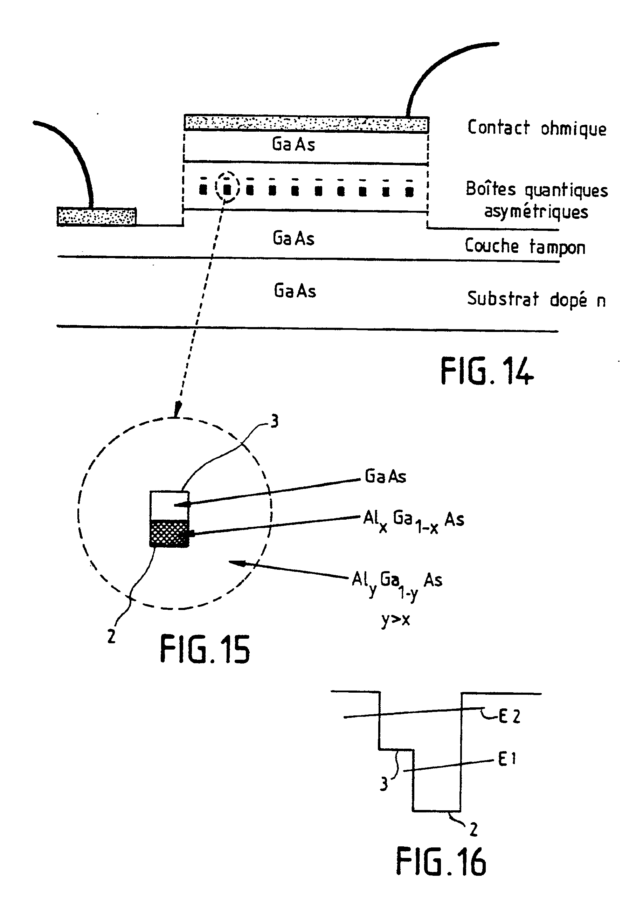

- les figures 14 à 16, un dispositif à boîtes quantiques assymétriques pour la détection photovoltaïque ;

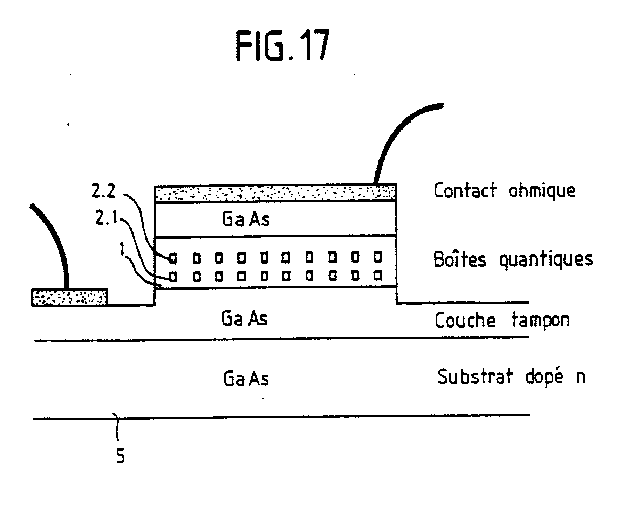

- la figure 17, un détecteur à photocourant de rayonnement à puits quantiques ;

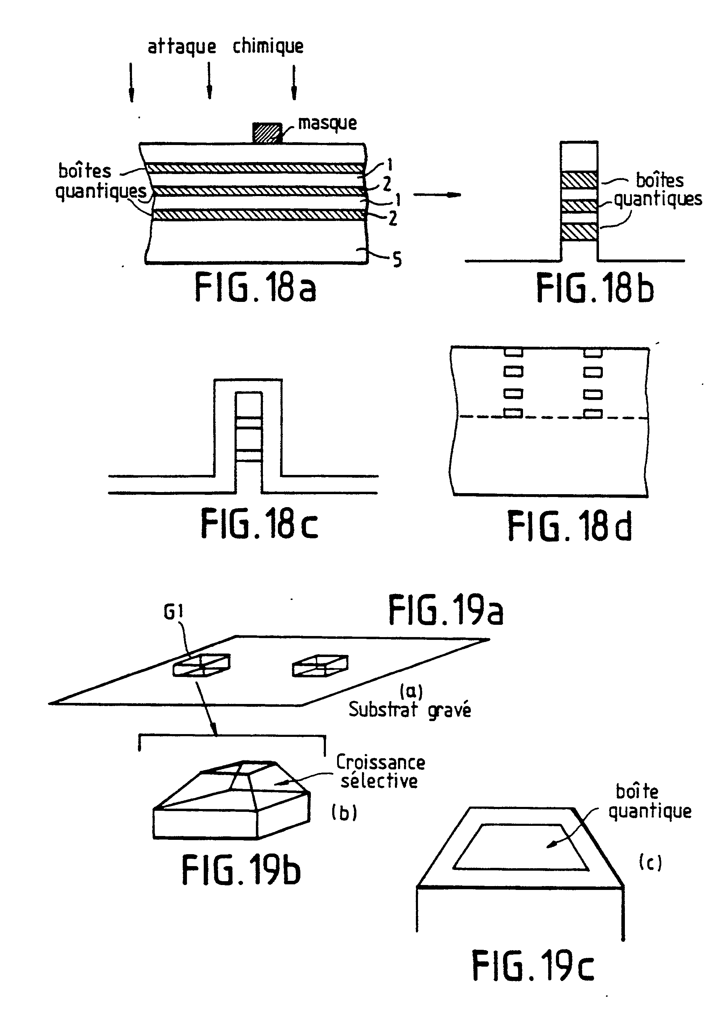

- les figures 18a à 18d un exemple de procédé de réalisation du dispositif de l'invention ;
- les figures 19a à 19c, un autre procédé de réalisation du dispositif de l'invention ;

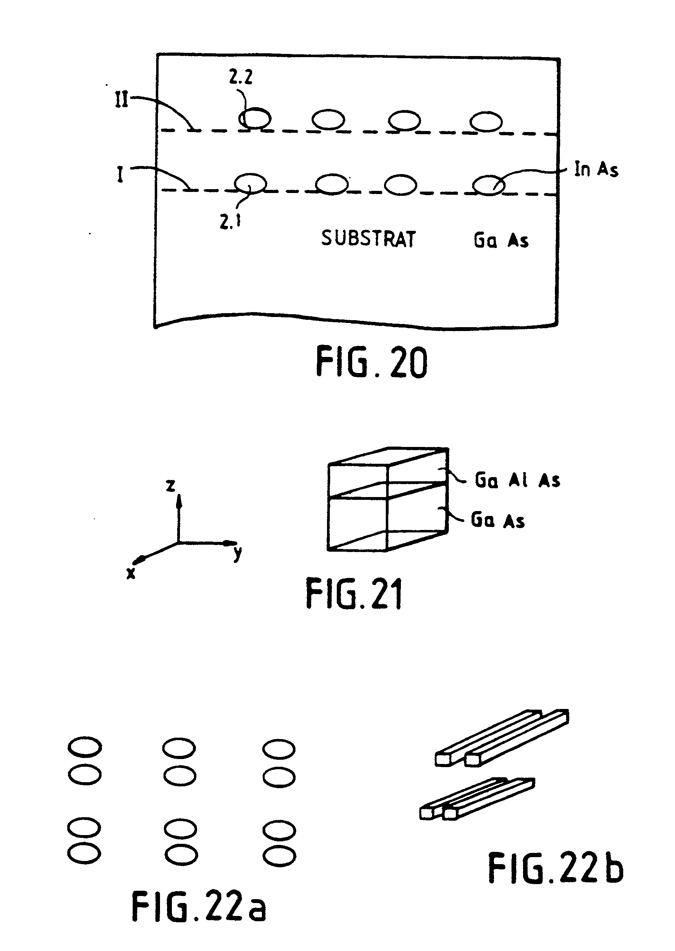

- la figure 20, un procédé de réalisation par nucléation du dispositif de l'invention ;
- la figure 21, une boîte quantique assymétrique ;
- les figures 22a et 22b, des boîtes quantiques et des fils quantiques couplés.

Une première réalisation de l'invention concerne un laser utilisant des transitions entre deux niveaux $E_{111}$ et $E_{112}$ d'une boîte quantique que l'on notera pour la suite $E_1$ et $E_2$.

Les figures 4a et 4b représentent des diagrammes d'énergie d'une boîte quantique selon l'invention.

La figure 4a représente la bande de conduction d'une telle boîte quantique et son fonctionnement intrabande.

A la partie inférieure de la figure 4a on a représenté une boîte quantique 2 incorporée dans un matériau 1.

Comme on peut le voir sur le diagramme de la figure 4a, l'énergie correspondant au bas de la bande de conduction de la boîte quantique 2 est inférieur au bas de la bande de conduction du matériau 1.

Les dimensions de la boîte 2 sont telles que deux niveaux quantiques permis sont compris dans le puits quantique c'est-à-dire entre les énergies des bas des bandes de conduction de la boîte quantique 2 et du matériau 1.

L'inversion de population peut se produire entre le niveau $E_2$ et le niveau $E_1$ grâce à la capture sélective des électrons sur le niveau $E_2$ à partir des états du continuum du matériau formant la matrice cristalline (matériau 2) alors que ces électrons vont relaxer lentement vers le niveau $E_1$

L'excitation vers le continuum des états de la matrice peut être fait de manière différente suivant la mise en oeuvre visée.

C'est ainsi que cette excitation peut se faire à l'aide d'une onde de pompe optique FP dont la l'énergie hv est supérieure ou au moins égale à la différence des niveaux d'énergie $E_2$ - $E_1$.

Si la boîte quantique 1 contient des électrons par dopage d'un des matériaux (1 ou 2), on peut donc exciter ces électrons vers les états du continuum par pompage optique à l'aide de toute source lumineuse adéquate. Les électrons relaxeront par émission rapide de phonons jusqu'au niveau 2 (voir figure 4a).

La figure 4b représente la bande de valence (niveaux de trous et la bande conduction (niveaux des électrons) du dispositif représenté en bas de la figure 4b.

On peut aussi exciter des électrons à partir des états de valence par transition interbande, créant des trous dans la boîte quantique et/ou dans le matériau du continuum. Ces trous vont permettre la recombinaison des électrons présents dans les boîtes dans l'état fondamental $E_1$, et donc mener à une inversion de population dès qu'un électron sera capturé dans l'état E2 d'une boîte quantique ainsi vidée (figure 4b). S'il n'y a pas initialement d'électrons dans la boîte, il y a inversion dès la capture dans l'état $E_2$.

Pour cela on réalise un pompage de la structure à l'aide d'une onde de pompe FP d'énergie hv égale ou supérieure à :

$$E_G + E'_1 + \Delta E_C$$

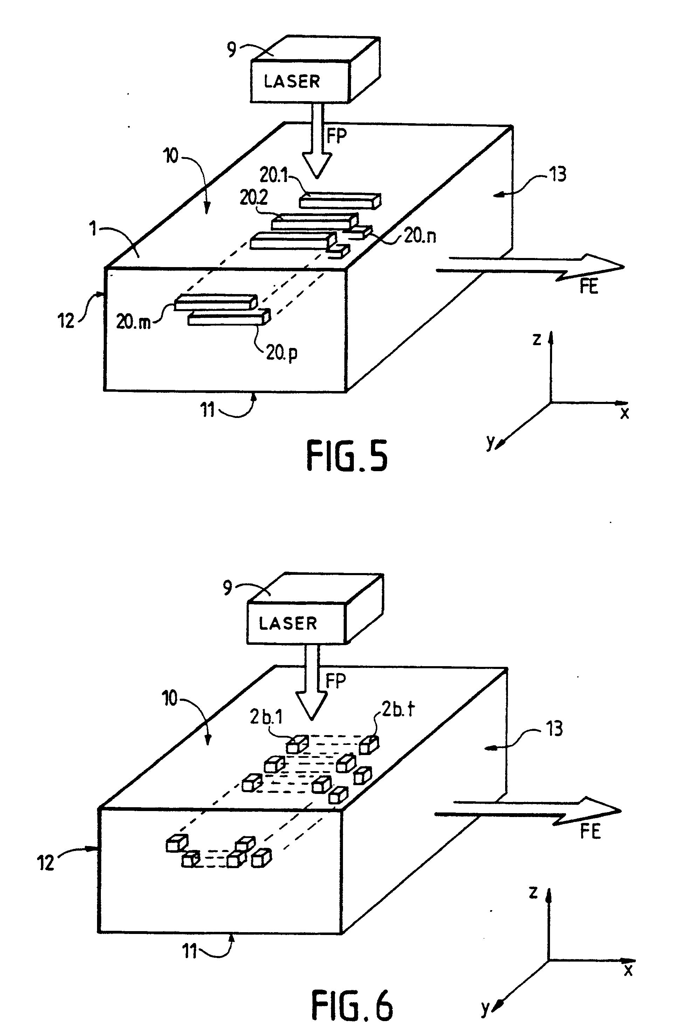

La figure 5 représente un exemple de réalisation d'un laser pompé par diode laser selon l'invention.

Ce laser est réalisé en matériau semiconducteur transparent à la longueur d'onde d'une onde de pompe. Il comporte une couche 1 en matériau semiconducteur disposé selon une trièdre xyz avec ces faces principales disposées selon le plan xy. La couche 1 comporte des lignes quantiques 20.1 à 20.m disposées parallèlement à la direction x. Ces lignes sont espacées de façon à ce qu'il n'y ait pas de couplage électronique entre elles.

Le matériau des lignes quantiques est choisi de façon que l'énergie du bas de la bande de conduction soit inférieur à celui du matériau de la couche 1

Les faces 12 et 13 sont clivées ou traitées de façon à être réfléchissantes à la fréquence d'émission du laser et constituent une cavité optique.

L'orientation des lignes quantiques par rapport aux faces 12 et 13 est telle que ces lignes sont perpendiculaires aux plans des faces 12 et 13.

L'émission lumineuse FE a donc lieu selon une direction perpendiculaire aux faces 12 et 13.

Selon un mode de réalisation préféré de l'invention les lignes quantiques 20.1 à 20.m sont disposées selon un plan parallèle aux faces 10 et 11. Le faisceau de pompe FP émis par une diode laser 9 est reçu perpendiculairement au plan de ces lignes quantiques.

Plusieurs plans de fils quantiques parallèles peuvent être prévues. Sur la figure 5, deux plans de fils 20.1 à 20.m et 20.n à 20.p ont été représentées, mais d'autres plans de fils quantiques peuvent être prévus.

De plus, selon une réalisation préférée de l'invention, des fils quantiques 20.n à 20.p et les fils quantiques 20.1 à 20.n sont disposées en quinconce par rapport à la direction de l'onde de pompe FP. De cette façon, l'onde de pompe FP permettra d'exciter le maximum de fils quantiques.

La figure 6 représente un laser selon l'invention dans lequel la couche de matériau semiconducteur comporte des boîtes quantiques. L'exemple de réalisation de la figure 6 est dérivé de l'exemple de réalisation de la figure 5 en remplaçant les fils quantiques telles que 20.1 par des rangées de boîtes quantiques telles que 2b.1 à 2b.t.

Une autre réalisation de l'invention concerne un laser excité électriquement.

Pour cela on réalise, comme cela est réalisé en figure 7, une structure comportant dans une couche 1 d'un matériau semiconducteur, des lignes de boîtes quantiques telles que 2b.1-2b.s et 2b.2-2b.t. Ces lignes de boîtes sont disposées entre les électrodes 4 et 5 et sensiblement perpendiculairement à ces électrodes.

Les électrodes 4 et 5 sont réalisées de façon à présenter un même type de conductivité.

Comme cela est représenté en figure 8, les faces latérales 12 et 13 du dispositif sont clivées ou traitées pour former des miroirs et réaliser ainsi une cavité optique.

La figure 9 représente un diagramme d'énergie de ce laser lorsque une différence de potentiel par le générateur 6 aux électrodes 4 et 5.

Les lignes de boîtes quantiques sont suffisamment proches pour qu'elles communiquent par effet tunnel.

La figure 9 représente une possibilité de transfert où les électrons communiquent de boîte en boîte en passant par effet tunnel résonant du niveau fondamental $E_1$ de l'une à l'état excité $E_2$ de l'autre. Comme la probabilité de sortie du niveau $E_2$ par excitation vers le continuum ou un autre état $E_2$ est bien plus forte que par des excitations vers le niveau $E_1$, on réalise ainsi l'inversion de population.

Une variante de ce dispositif est indiqué sur la figure 10, où l'on injecte les électrons par effet tunnel à partir d'un niveau large, comme un puits quantique large Q1, ce qui permet la collection d'une grande densité d'électrons à partir de l'électrode injectante avant leur transfert tunnel efficace dans les boîtes comme cela est représenté par le diagramme d'énergie de la figure 11. On peut aussi noter que si l'émission thermoionique des électrons dans les boîtes est plus rapide que la relaxation du niveau 2 au niveau 1, le transport électronique dû à l'émission thermoionique conduit aussi à l'inversion de population.

Le dispositif de l'invention peut être également appliqué à la réalisation d'un modulateur optique.

Pour cela, dans les techniques connues on cherche à avoir des matériaux au coefficient électro-optique le plus élevé, ce qui permet la commande par des tensions faibles et/ou des tailles de dispositifs faibles.

Selon l'invention, on réalise un modulateur à l'aide de fils quantiques ou de boîtes quantiques tels que le modulateur représenté en figure 12. Ces fils ou boîtiers quantiques sont constitués de matériaux semiconducteurs façonnés de telles manière que deux ou trois de leurs dimensions soient de taille de l'ordre de la longueur d'onde de Broglie des électrons soit environ 20 nm.

Le modulateur de la figure 12 comporte sur un substrat S dopé n+ ou semi-isolant recouvert d'une couche dopée, une couche 1 d'un matériau semiconducteur transparent à une longueur d'onde à moduler.

La couche 1 contient des fils (ou lignes) quantiques 2.1 à 2.2' disposés parallèlement au plan de la couche 1 et orthogonaux à la direction du faisceau lumineux à moduler. Les électrodes 4 et 5 sont situées de part et d'autre de la couche 1 et une source de tension G est connectée à ces électrodes. Ces électrodes sont d'un même type de conductivité. Le flux lumineux à moduler est dirigé selon le faisceau FM parallèlement au plan de la couche ou selon le faisceau FM' perpendiculairement au plan de la couche, l'électrode 5 étant alors transparente.

Pour améliorer la modulation, la couche 1 peut être encadrée par des couches de guidage optique G1 et G2.

Le gain espéré de telles structures provient de plusieurs propriétés :
- la densité des états quantiques étant caractéristique de système uni ou zéro-dimensionnels (figures 13a, 13b) tout déplacement de niveau induit par champ va se traduire par un effet important sur le spectre d'absorption (voir figures 13c, 13d) ;
- les niveaux d'énergie du système zéro-dimensionnel (boîte quantique) étant discrets, les effets de relaxation d'énergie sont très ralentis, voire empêchés pour toute transition à un phonon dès lors que la distance entre niveaux quantiques est supérieure à l'énergie du phonon optique, (soit 36 meV pour GaAs) ;
- il peut être avantageux d'utiliser des systèmes ayant une asymétrie (figure 21), ou permettant le transfert de charges tels que les boîtes ou fils quantiques couplés (figures 22a et 22b), car le transfert de charge se produit sur une distance plus grande que dans les systèmes simples, conduisant à des dipôles électriques, donc des polarisations, plus grands lorsqu'un champ électrique est appliqué.

Cet effet peut être utilisé aussi lorsque l'invention est mise en oeuvre dans un dispositif bi-stable optique ou électrooptique analogue aux dispositifs réalisés en films quantiques fonctionnant par transitions interbandes décrit par exemple dans le document : D.A.B. Miller, Quantum wells for optical information processing, optical engineering 26-368 (1987).

On peut utiliser le modulateur comme modulateur d'amplitude (grâce au changement d'absorption créé par le champ électrique) ou de phase (grâce au changement d'indice, lié à l'absorption par les relations de Kramers-Kronig).

Les figures 14 à 16 représentent une variante de l'invention dans lesquels les puits (boîtes ou fils) quantiques (boîtes quantiques par exemple) sont réalisés sous la forme de structures constituées de puits quantiques asymétriques qui présentent des propriétés d'optique non linéaire renforcées. Ces propriétés ont été décrites dans les documents suivants :

E. Rosencher, P. Bois, J. Nagle, E. Costard, and S. Delaître, Applied Physics Letters 25, 1150 (1989) ;

E. Rosencher, P. Bois, J. Nagle, and S. Delaître, Electronic Letters 25, 1063 (1989),

Ces propriétés peuvent être utilisées pour la détection et le traitement optique de radiations électromagnétiques. Dans ces puits quantiques asymétriques, en plus du potentiel asymétrique construit le long de l'axe de croissance, on a créé un double confinement latéral. Ceci permet d'obtenir de véritables "superatomes" asymétriques dans une seule direction, avec des niveaux d'énergie complètement discrets dont l'espacement peut être ajustée par les paramètres de croissance, choix des matériaux et dimensions $L_x$, $L_y$, $L_z$ de la boîte.

Comme cela est représenté sur les figures 14 et 15 chaque boîte quantique est constituée d'un matériau 2 et d'un matériau 3 tel que l'ensemble présente un profil des énergies de la bande de conduction représenté en figure 16.

Le matériau 2 présente une énergie du bas de la bande de conduction la plus faible tandis que le matériau 1 présente une énergie plus élevée et constitue les barrières du puits.

Le puits (boîte) quantique présente un premier niveau permis E1 situé dans la partie la plus étroite du puits et un deuxième niveau permis E2 situé dans la partie la plus large du puits.

Lors d'une illumination par une radiation électromagnétique de longueur d'onde d'excitation déterminée, l'électron contenu sur le niveau fondamental E1 de la boîte est transféré sur un niveau excité E2, si la différence des énergies est sensiblement égale à la longueur d'onde lumineuse d'excitation. Ces deux niveaux ont des barycentres distincts le long de l'axe de croissance et un dipôle électrique va se développer dans la structure, introduisant de fortes propriétés non linéaires. Le temps de vie de ce dipôle, donc l'ampleur des effets observés est directement lié à la durée de vie de l'état excité. Dans les simples puits asymétriques, ce temps est court, de l'ordre de 0.1 ps, car les états 2D sont non quantifiés selon les autres directions intermédiaires et seule une recombinaison radiative vers le niveau fondamental est permise. La durée de vie dans l'état excité sera plus grande, d'environ 10 ns et les coefficients non linéaires sont 5 ordres de grandeur plus importants.

Ce dispositif peut être utilisé pour la détection de rayonnements électromagnétiques. Dans ce cas ces dipôles vont alors être détectés aux bornes du dispositif contenant de telles boîtes quantiques. Le dispositif est muni d'électrodes d'un même type de conductivité auxquelles sont connectées un détecteur.

On peut utiliser d'autres propriétés non linéaires d'une telle structure, en introduisant éventuellement un troisième niveau (qui peut être virtuel) pour des processus à plusieurs photons comme la génération de seconde harmonique, l'hétérodynage ou l'amplification paramétrique.

Ces boîtes quantiques peuvent être réalisées par des couples de boîtes constituant chacun un dipôle avec les mêmes applications que pour les boîtes asymétriques.

Ce dispositif peut être utilisé pour la détection de rayonnements électromagnétiques. Dans ce cas ces dispositifs fonctionneront de manière optimale jusqu'à des longueurs d'onde de 40 µm.

Un autre intérêt des boîtes quantiques par rapport aux films quantiques est le suivant.

Pour coupler la lumière incidente et le dipôle, il faut impérativement une lumière polarisée parallèle à l'axe de croissance dans le cas des films quantiques, c'est-à-dire qu'il faut illuminer à l'angle de Brewster pour avoir un maximum de couplage, et même dans ce cas il n'est que de 1%.

Dans le cas des boîtes, le niveau excité est en fait un niveau trois fois dégénéré et si l'écart entre les niveaux $E_1x$, $E_{1y}$, $E_{1z}$ est inférieur à 36 meV soit l'énergie d'un phonon LO, toutes les polarisations de la lumière incidente permettront une excitation optique et dans tous les cas une partie des électrons relaxera vers le niveau $E_{1z}$ par diffusion avec des phonons acoustiques ou des impuretés et le dipôle sera effectivement créé selon l'axe z.

Enfin, comme autre application, la structure de boîtes quantiques décrite peut aussi être utilisée comme dispositif pour la détection de rayonnement électro-magnétique par photocourant. La figure 17 montre un tel dispositif : sur un substrat dopé S on fait croître une couche tampon dopée du même matériau, ensuite une ou plusieurs couches de la structure à boîtes quantiques, suivi par une couche dopée du matériau à faible bande interdite. Par des méthodes standards de microlithographie on forme un mésa et on munit le substrat d'un contact ohmique et la couche supérieure d'un contact ohmique transparent au rayonnement à détecter. Ces deux contacts ohmiques sont d'un même type de conductivité. Le fonctionnement du dispositif est le suivant: une tension électrique est appliquée sur les contacts. Le rayonnement d'une longueur d'onde déterminée excite les électrons initialement dans le niveau le plus bas des puits quantiques :

- soit vers un niveau supérieur du puits si la différence des énergies du niveau excité et du niveau fondamental est sensiblement égale à la longueur d'onde d'excitation ;

- soit au dessus de la bande de conduction du matériau barrière ; ensuite les électrons sortent du puits par effet tunnel sous la force du champ électrique établi par la tension appliquée, ce qui crée un courant mesurable dans le circuit extérieur.

Par rapport à l'état de l'art antérieur des puits quantiques bidimensionnels l'avantage de la structure proposée est :

- les électrons peuvent être excités même par un champ électromagnétique de polarisation parallèle à la surface, ce qui augmente le couplage et donc l'absorption considérablement ;

- la probabilité de recapture dans un autre puits d'un électron éjecté est réduite parce que l'interaction avec les vibrations du réseau cristallin ne permet pas en premier ordre un tel capture dans le cas d'un niveau complètement discret dans la boîte.

La fabrication de boîtes quantiques ou de fils quantiques peut être effectuée de plusieurs manières.

Selon le procédé représenté par les figures 18a à 18d on réalise sur un substrat S des couches alternées de matériau correspondant dans la description précédente, aux matériaux de la couche 1 et des puits quantiques 2 (figure 18a).

Puis on grave par masquage des éléments de la dimension des boîtes (ou des fils) quantiques (voir figure 18b). On sait réaliser des gravures conduisant à des éléments de section 80 nm × 80 nm. De telles sections géométriques conduiront à des boîtes d'environ 20 à 30 nm du point de vue électronique.

Enfin, on réalise un dépôt d'un matériau identique à la couche 1 (figure 18c) et si nécessaire on planarise la structure (figure 18d).

Selon un autre procédé représenté par les figures 19a et 19b on réalise par gravure d'un substrat des éléments G1 (figure 19a).

Ensuite on réalise, sur ce substrat gravé, une croissance sélective (figure 19b) qui crée des anisotropies de deux manières différentes : dans la direction de croissance grâce à la directionalité de la croissance ; dans une direction perpendiculaire à celle de croissance en gravant des motifs asymétriques. Ce procédé de croissance sélective créant différentes directions de croissances est décrit dans le document : YD Galeuchet, P. Roentgen and V. Graf, Applied, Physic. Letter 53, 2628 (1988). La structure est ensuite planarisée si nécessaire comme dans le procédé précédent.

Enfin, selon le procédé représenté en figure 20, on peut aussi fabriquer des boîtes quantiques par nucléation tridimensionnelle sur une interface planaire I. Le procédé de nucléation est décrit dans le document : L. Goldstein, F. Glas, J.Y. Marzin, M.N. Charasse and G. Le Roux, Applied Physics, Letters 47, 1099 (1895). Cette méthode permet facilement d'obtenir des asymétries dans la direction de croissance en variant les flux au cours de la croissance, ainsi que des boîtes quantiques couplées si la distance entre boîtes est suffisamment faible pour permettre la délocalisation de fonctions d'ondes entre deux boîtes quantiques adjacentes. Après avoir réalisé des boîtes quantiques telles que 2.1 sur une surface I, on réalise un dépôt d'un matériau identique au substrat. On obtient une autre surface II (indiquée en pointillés) sur laquelle on réalise à nouveau des boîtes quantiques telles que 2.2 et ainsi de suite.

On a partout représenté les boîtes quantiques sous formes de cubes par simplicité. Toute forme est acceptable, du moment que les dimensions caractéristiques sont de l'ordre de, ou inférieures à, la longueur d'onde de Broglie des électrons.

Les matériaux actifs peuvent être de natures très variées, tels que par exemple des familles IV, III-V, II-VI ou IV-VI. Il n'est pas indispensable que la localisation des trous ait lieu dans les boîtes (ou les fils) dans lesquelles les électrons sont quantifiés. Mais les trous peuvent être localisés dans le matériau entourant les boîtes. Cela dépend des matériaux utilisés. Ce pas peut être obtenu avec un couple de matériau GaSb/InAs.

La description précédente a été faite pour des structures en considérant que les particules actives sont des électrons, mais on pourrait concevoir ces structures en considérant que les particules actives sont des trous en changeant le dopage de type N en dopage de type P.

Il est bien évident que la description qui précède a été faite qu'à titre d'exemple non limitatif et que d'autres variantes peuvent être envisagées sans sortir du cadre de l'invention. Les exemples numériques et la nature des matériaux et les méthodes de fabrication indiqués n'ont été fournis que pour illustrer la description.

## Revendications

1. Dispositif optique à puits quantique caractérisé en ce qu'il comporte :
   - une couche (1) d'un matériau semiconducteur transparent à des ondes lumineuses possédant une valeur d'énergie potentielle déterminée correspondant au bas de la bande de conduction pour les électrons ;
   - au moins un puits quantique (2, 20, 21...) limité dans deux dimensions (fil quantique) ou dans trois dimensions (boîte quantique ou point quantique) le matériau constituant ce puits quantique de valeur d'énergie potentielle du bas de la bande de conduction inférieure à celle de la couche de matériau semiconducteur transparent et possédant au moins un premier niveau électronique permis (niveau fondamental) et un deuxième niveau électronique permis dont les énergies correspondantes sont comprises entre les valeurs d'énergie potentielle des bas de bandes de conduction précédentes ;
- des moyens de peuplement en électrons du premier niveau électronique permis.

2. Dispositif optique à puits quantique selon la revendication 1, caractérisé en ce que les moyens de peuplement en électrons sont des dopages de type N ou de type P des boîtes ou du matériau entourant les boîtes.

3. Dispositif optique à puits quantique selon la revendication 1, caractérisé en ce que les moyens de peuplement en électrons comporte un faisceau de pompage qui va créer des électrons et des trous, dont l'énergie est supérieure au gap de la boîte.

4. Dispositif optique à puits quantique selon la revendication 1, caractérisé en ce qu'il comporte plusieurs puits quantiques limités dans deux dimensions ou trois dimensions.

5. Dispositif optique à puits quantique selon la revendication 1, caractérisé en ce que les puits quantiques sont espacés d'une distance suffisante interdisant leur couplage électronique.

6. Dispositif optique selon la revendication 4, caractérisé en ce que la couche est disposée parallèlement à un plan yx et qu'elle comporte plusieurs fils quantiques disposées parallèlement à ce plan xy.

7. Dispositif optique selon la revendication 6, caractérisé en ce qu'il comporte plusieurs plans de fils quantiques, ces plans étant parallèles entre eux.

8. Dispositif optique selon la revendication 7, caractérisé en ce que les fils quantiques d'un plan sont situées en quinconce par rapport aux fils quantiques d'un autre plan par rapport à la direction z du trièdre xyz.

9. Dispositif optique selon la revendication 4, caractérisé en ce que la couche est disposée parallèlement à un plan xy et qu'elle comporte plusieurs boîtes quantiques alignées selon une ligne parallèle au plan xy.

10. Dispositif optique selon la revendication 9, caractérisé en ce qu'il comporte plusieurs lignes parallèles de boîtes quantiques disposées dans un plan parallèle au plan xy.

11. Dispositif optique selon la revendication 10, caractérisé en ce qu'il comporte plusieurs plans parallèles de boîtes quantiques.

12. Dispositif optique selon la revendication 11, caractérisé en ce que les boîtes d'un plan sont placées en quinconce avec les boîtes d'un plan voisin par rapport à la direction z du trièdre xyz.

13. Dispositif optique selon -la revendication 1, caractérisé en ce que la couche (1) de matériau semiconducteur possède un premier indice de réfraction (n1) et est encadrée par deux couches d'un matériau d'un deuxième indice de réfraction (n2) inférieur au premier indice de réfraction.

14. Dispositif optique à puits quantique selon la revendication 1, caractérisé en ce que :
- la couche (1) étant orientée avec ses faces principales (10, 11) parallèles à un plan xy d'un trièdre xyz, les puits quantiques sont orientés selon la direction x ;
-des faces (12, 13) de la couche (1) perpendiculaires à la direction x sont clivées ou traitées optiquement pour constituer une cavité optique ;
- une source auxiliaire (9) fournit une onde de pompe sensiblement perpendiculairement aux faces principales.

15. Dispositif optique à puits quantique selon la revendication 12, caractérisé en ce que l'énergie de l'onde de pompe fournie par la source auxiliaire (9) est supérieure à la différence d'énergies du deuxième niveau permis et du deuxième niveau permis.

16. Dispositif optique à puits quantique selon la revendication 14, caractérisé en ce que la longueur de l'onde de pompe fournie par la source auxiliaire (9) est supérieure ou égale à l'énergie de transition interbandes (EK) (bande de conduction - bande de valence) du semiconducteur constituant la boîte, plus la discontinuité de bande ($E_c$) entre le matériau de la boîte et le matériau entourant la boîte, plus l'énergie de confinement des trous ($E'_1$).

17. Dispositif optique selon la revendication 1, caractérisé en ce que
    - la couche (1) du matériau semiconducteur transparent comporte deux faces principales (10) et (11) parallèles à un plan xy d'un trièdre xyz et équipées chacune d'une électrode d'un même type de conductivité ;
    - un générateur (G) de tension est connecté à ces électrodes pour appliquer une différence de potentiel à la structure ;
    - des faces (12, 13) de la couche (1) perpendiculaires à la direction x sont clivées ou traitées pour constituer une cavité optique.

18. Dispositif optique selon la revendication 17, caractérisé en ce qu'il comporte plusieurs puits quantiques disposés dans un plan parallèle au plan xy.

19. Dispositif selon la revendication 17, caractérisé en ce qu'il comporte une couche quantique parallèle à l'une des électrodes et que le générateur applique un potentiel négatif à cette électrode par rapport au potentiel appliqué à l'autre électrode

20. Dispositif selon la revendication 19, caractérisé en ce que le matériau constituant la couche quantique est similaire à celui du puits quantique (2).

21. Dispositif optique selon la revendication 1, caractérisé en ce qu'il comporte des électrodes de même type de conductivité sur les deux côtés de la couche (1) de matériau semiconducteur transparent et un détecteur de différence de potentiel connecté à ces électrodes.

22. Dispositif optique selon la revendication 1, caractérisé en ce qu'il comporte une électrode de chaque côté de la couche (1) de matériau semiconducteur transparent et une source de tension appliquant une différence de potentiel aux électrodes, un faisceau lumineux eux étant transmis dans la couche (1) pour être modulé par le dispositif.

23. Dispositif optique selon l'une des revendications 21 ou 22, caractérisé en ce qu'il comporte plusieurs puits quantiques couplés par deux, deux puits couplés étant séparés par une distance permettant entre eux un couplage électronique.

24. . Dispositif optique selon l'une des revendications 21 ou 22, caractérisé en ce que chaque puits comporte deux types de matériaux (2, 3) accolés l'un à l'autre, les énergies du bas de la bande de conduction de ces matériaux étant différentes pour les deux types de matériaux.

25. Dispositif optique selon la revendication 1, caractérisé en ce que chaque puits comporte deux types de matériaux (2, 3) accolés l'un à l'autre, les énergies du bas de la bande de conduction de ces matériaux étant différentes pour les deux types de matériaux.

26. Procédé de réalisation d'un dispositif optique selon l'une quelconque des revendications précédentes caractérisé en ce qu'il comporte :
    - une première étape de réalisation sur un substrat de couches alternées de deux matériaux, possédant des largeurs de bande interdite différentes ;
    - une deuxième étape de gravure dans ces couches d'éléments individuels.

27. Procédé de réalisation d'un dispositif optique selon la revendication 26, caractérisé en ce qu'il comporte une étape de planarisation de la structure obtenue à l'aide d'un matériau de largeur de bande interdite sensiblement égale à celle desdits matériaux ayant la plus grande largeur de bande interdite.

28. Procédé de réalisation d'un dispositif optique selon l'une quelconque des revendications 1 à 23, caractérisé en ce qu'il comporte les étapes suivantes :
    - une étape de réalisation sur un substrat en matériau semiconducteur, d'au moins un élément du même matériau ;
    - une étape de croissance sélective sur les éléments de ce substrat d'un matériau semiconducteur alterné avec un autre matériau, les bandes interdites de ces matériaux étant différentes ;
- et éventuellement une étape de planarisation de la structure à l'aide d'un matériau à grande largeur de bande interdite.

29. Procédé de réalisation d'un dispositif optique selon l'une quelconque des revendications 1 à 21 caractérisé en ce qu'il comporte des étapes alternées, sur une face d'un substrat de grande bande interdite, de nucléation de particules de matériau semiconducteur de faible bande interdite et des étapes de planarisation à l'aide d'un matériau identique au matériau du substrat.

30. Procédé de réalisation selon la revendication 26, caractérisé en ce que la première étape de réalisation comporte une réalisation de couches alternées d'au moins trois matériaux de largeurs de bandes interdites différentes.

31. Procédé de réalisation selon la revendication 26, caractérisé en ce qu'il comporte au moins une étape de dopage de type P ou N de l'un des deux matériaux.

32. Procédé de réalisation selon la revendication 30, caractérisé en ce qu'il comporte une étape de dopage de type P ou N de l'un au moins des trois matériaux.

FIG.1a

FIG.1b

état quantique
1   1   1
$(n_x = 1, n_y = 1, n_z = 1)$

FIG.2

FIG.3

FIG.4a

FIG.4b

FIG.5

FIG.6

FIG.7

FIG.8

FIG.9

Electrode  Q1  2  1  Face clivée  SUBSTRAT

FIG.10

Puits quantique large

FIG.11

FM'

ELECTRODE
5
$G_1$

2.1' | | 2.2'
2.1 | | 2.2

F

$G_2$

4 SUBSTRAT

G

# FIG.12

E

Densité des états d'énergie
$E_2$
$E_1$

a

n (E)

Fil quantique

E

Densité des états d'énergie

b

n (E)

Boîte quantique

E

$E_2'$
$E_2$
$E_1'$
$E_1$

n(E)

C

avec champ électrique

sans champ

Coefficient d'absorption

d

E

e

n(E)

E

f

n(E)

# FIG.13

Contact ohmique

GaAs

Boîtes quantiques
asymétriques

GaAs                Couche tampon

GaAs                Substrat dopé n

## FIG. 14

GaAs

$Al_x Ga_{1-x} As$

$Al_y Ga_{1-y} As$

$y > x$

3

2

## FIG. 15

E 2

E 1

3

2

## FIG. 16

# FIG.17

2.2

2.1

1

Contact ohmique

GaAs

Boîtes quantiques

GaAs     Couche tampon

GaAs     Substrat dopé n

5

attaque chimique

masque

boîtes
quantiques

1
2
1
2

5

## FIG. 18a

boîtes
quantiques

## FIG. 18b

## FIG. 18c

## FIG. 18d

## FIG. 19a

G1

(a)
Substrat gravé

Croissance
sélective

(b)

## FIG. 19b

boîte
quantique

(c)

## FIG. 19c

FIG. 20

FIG. 21

FIG. 22a

FIG. 22b

Office européen
des brevets

# RAPPORT DE RECHERCHE EUROPEENNE

Numero de la demande

EP 90 40 3445

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | ELECTRONICS LETTERS, vol. 24, no. 13, 23 juin 1988, pages 825-825; M. CAO et al.: "GaInAsP/InP single-quantum-well (SQW) laser with wire-like active region towards quantum wire laser" * Abrégé * --- | 1 | H 01 S 3/19 <br> G 02 F 1/015 <br> H 01 L 31/0352 |
| A | IEEE JOURNAL OF QUANTUM ELECTRONICS, vol. 25, no. 9, septembre 1989, pages 2001-2006; Y. MIYAMOTO et al.: "Threshold current density of GaInAsP/InP quantum-box lasers" * Abrégé * --- | 1 | |
| A | EP-A-0 306 400 (THOMSON-CSF) * Abrégé * --- | 1 | |
| D,A | OPTICAL ENGINEERING, vol. 26, no. 5, mai 1987, pages 368-372; D.A.B. MILLER: "Quantum wells for optical information processing" * Chapitre 2 * --- | 1 | **DOMAINES TECHNIQUES RECHERCHES (Int. Cl.5)** |
| D,A | ELECTRONICS LETTERS, vol. 25, no. 16, 3 août 1989, pages 1063-1065; E. ROSENCHER et al.: "Second harmonic generation by intersub-band transistions in compositionally asymmetrical MQWs" * Abrégé; figure 1 * ----- | 1 | H 01 S <br> G 02 F <br> H 01 L |

Le présent rapport a été établi pour toutes les revendications

| Lieu de la recherche | Date d'achèvement de la recherche | Examinateur |
|---|---|---|
| LA HAYE | 15-03-1991 | GALANTI M. |